# EUROPEAN PATENT APPLICATION

(11) **EP 1 850 401 A1**
(43) Date of publication of application: **31.10.2007**
(21) Application number: 06713773.7
(22) Date of filing: 15.02.2006
(51) Int. Cl.: H01L 33/00

(54) **SEMICONDUCTOR LIGHT EMITTING ELEMENT**

(30) Priority: 16.02.2005 JP 2005038752
(71) Applicant: Rohm, Co., Ltd., Kyoto-shi, Kyoto 615-0045 (JP)
(72) Inventor: ITO, Norikazu, Kyoto-shi, Kyoto, 6158585 (JP); TSUTSUMI, Kazuaki, Kyoto-shi, Kyoto, 6158585 (JP); NISHIDA, Toshio, Kyoto-shi, Kyoto, 6158585 (JP); SONOBE, Masayuki, Kyoto-shi, Kyoto, 6158585 (JP); SAKAI, Mitsuhiko, Kyoto-shi, Kyoto, 6158585 (JP); YAMAGUCHI, Atsushi, Kyoto-shi, Kyoto, 6158585 (JP)
(74) Representative: TBK-Patent
(86) International application number: PCT/JP2006/302632
(87) International publication number: WO 2006/088046

(57) **Abstract**

There is provided a nitride semiconductor light emitting device in which a semiconductor layer is not broken easily even when a reverse voltage is applied or even in long time operation, and excellent reliability is obtained, by preventing semiconductor layers from deterioration when manufacturing a device. On a surface of a substrate (1), a semiconductor lamination portion (6) made of nitride semiconductor, including a first conductivity type layer (p-type layer (5)) and a second conductivity type layer (n-type layer (3)), is formed, a p-side electrode (8) is provided through a light transmitting conductive layer (7) thereon electrically connected to the p-type layer (5), and an n-side electrode (9) is provided electrically connected to the n-type layer (3) of the lower layer side of the semiconductor lamination portion (6). A mesa-like semiconductor lamination portion (6a) is formed by removing a part of the semiconductor lamination portion (6) around a chip by etching, and the mesa-like semiconductor lamination portion (6a) is formed such that a corner part having an angle of 90 degrees or less is rounded and has a curved line in a plan shape, thereby not to have an angle of 90 degrees or less on corner parts.

## Description

### FIELD OF THE INVENTION

The present invention relates to a semiconductor light emitting device using nitride semiconductor suitable for emitting blue type light (from ultraviolet light to yellow light). More particularly, the present invention relates to a semiconductor light emitting device having a structure in which uniformity of emitting light on the entire area of a surface of a chip is obtained, and at the same time, break down caused by static electricity or long time operation or the like hardly occurs.

### BACKGROUND OF THE INVENTION

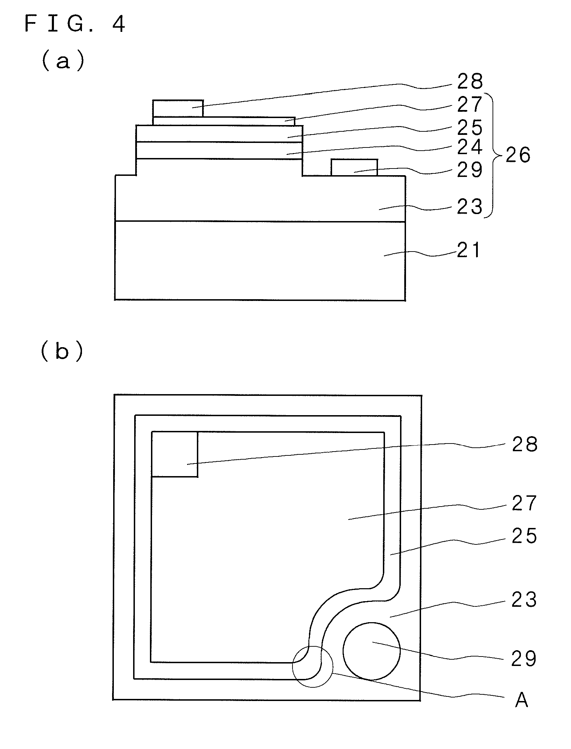

A semiconductor light emitting device emitting blue type light is formed by laminating nitride semiconductor layers on an insulating substrate made of sapphire, as, for example, a schematic cross-sectional view of an example of a light emitting device chip (hereinafter referred to as LED chip) thereof is shown in Fig. 4(a). Namely, a semiconductor lamination portion 26 is formed, on a sapphire substrate 21, by laminating an n-type layer (clad layer) 23 made of, for example, n-type GaN epitaxially grown, an active layer 24 made of a material having a smaller band gap energy than that of the clad layer, for example, InGaN based (which means that a ratio of In to Ga can be varied variously and the same applies hereinafter) compound semiconductor, and a p-type layer (clad layer) 25 made of p-type GaN, and then the LED chip is formed by providing a p-side (upper) electrode 28 on the semiconductor lamination portion through a light transmitting conductive layer 27 made of ZnO, and providing an n-side (lower) electrode 29 on a surface of the n-type layer 23 exposed by etching a part of the semiconductor lamination portion.

On the other hand, a light emitting device using such semiconductor material as nitride semiconductor of this kind among semiconductor light emitting devices is especially weak against a reverse voltage, and easily breaks when a surge such as static electricity or the like enters. This break down is occasionally occurs in a part of the active layer because the active layer is highest in an electric resistance and easy to absorb a high voltage, and it is understood like that the break down spreads from a part where a high voltage is easily concentrated to the whole active layer. Then, it is known that, as a special part, where a voltage is easily concentrated, is a portion shown by 'A' in an explanatory plan view of Fig. 4(b). In the portion, a voltage is easily most concentrated, when an angle part is formed on a part opposing to the n-side electrode 29 in a plan shape, and damage enters from the angle part into the center of the active layer. And it is disclosed that a corner part of the part opposing to the n-side electrode 29 is formed so as not to have an angle part but to have a curved line (cf. for example PATENT DOCUMENT 1).
PATENT DOCUMENT 1: Japanese Patent Application Laid-Open No. HEI11-177133

### DISCLOSURE OF THE INVENTION

### PROBLEM TO BE SOLVED BY THE PRESENT INVENTION

As described above, concentration of an electric field is inhibited by rounding a shape of a mesa structure of the semiconductor lamination portion on opposing parts of the p-type layer of the mesa structure and the n-side electrode, which are portions on directions of electric current flow, thereby preventing the light emitting device from being apt to break down by static electricity, application of voltage or the like, especially by application of a reverse voltage. However, even if the steps are taken, there are such problems that breaking down easily occurs by entrance of a surge or the like in the light emitting device using nitride semiconductor, and light emitting characteristics such as decreasing of luminance deteriorates drastically in accordance with operation time.

The present invention is directed to solve the above-described problem and an object of the present invention is to provide a nitride semiconductor light emitting device in which a semiconductor layer is not broken easily even when a reverse voltage is applied or even in long time operation, and excellent reliability is obtained, by preventing semiconductor layers from deterioration when manufacturing a device.

### MEANS FOR SOLVING THE PROBLEM

The present inventors examined and studied earnestly a cause of deterioration of characteristics such as breaking down easily by entering of static electricity or decreasing in luminance in rather short operation time in a light emitting device using nitride semiconductor, and as a result, it was found that if there is a part suffered from a damage in a part of a semiconductor layer especially such as an active layer or the like, the damage spreads within a whole area of the semiconductor layer suffered from the damage such as the active layer or the like and that the crystalline structure of the semiconductor layer deteriorates remarkably. And it was further found that if there exists a corner part having an angle part of 90 degrees or less on a dry etching process for etching a part of the semiconductor lamination portion for forming the n-side electrode and forming a groove around a chip for separating into chips, as described above, the corner part is suffered from a damage by the dry etching process, the damage spreads within the semiconductor layer, and the deterioration of characteristics is raised.

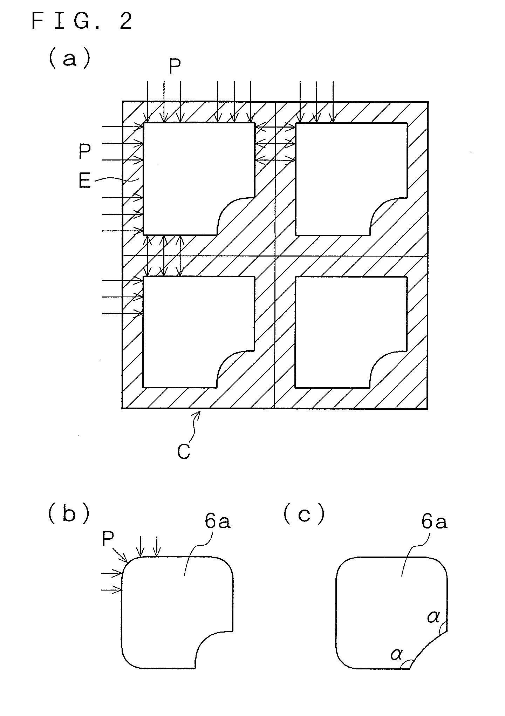

Namely, it was found that, as shown in Fig. 2(a) described later, since plasma P in the etching process is concentrated at the corner part from two sides intervening the corner edge, the semiconductor layer is suffered from damage, the damage spreads within a whole area of the semiconductor layer by LED operation or the like and leads to deterioration of most of parts of the semiconductor layer, and decrease of luminance, break down or the like arises. And it was also found that the plasma P can be prevented from concentrating at a special part of the semiconductor layer upon the etching process by eliminating an angle part of 90 degrees or less, damage to the semiconductor layer can be inhibited, and a semiconductor light emitting device of long life time and strong against a surge such as static electricity or the like can be obtained.

A semiconductor light emitting device according to the present invention includes: a substrate; a semiconductor lamination portion made of nitride semiconductor provided on the substrate, the semiconductor lamination portion including a first conductivity type layer and a second conductivity type layer; a light transmitting conductive layer provided on the semiconductor lamination portion; a first electrode provided on the light transmitting conductive layer and electrically connected to the first conductivity type layer which is provided on a surface side of the semiconductor lamination portion; and a second electrode provided electrically connected to the second conductivity type layer of a lower side of the semiconductor lamination portion, wherein a mesa-like semiconductor lamination portion is formed by etching the semiconductor lamination portion of at least a surrounding region of a chip such that a corner part having an angle of 90 degrees or less is rounded and has a curved line in a plan shape, thereby not to have an angle of 90 degrees or less on corner parts.

Here, a nitride semiconductor means a semiconductor made of a compound of Ga of group III element and N of group V element, or a compound in which a part or all of Ga of group III element substituted by other element of group III element like Al, In or the like and/or a part of N of group V element substituted by other element of group V element like P, As or the like. A first conductivity type and a second conductivity type also mean that, when any one of an n-type or a p-type of polarities of semiconductor is referred to as the first conductivity type, the p-type or the n-type of the other type is referred to as the second conductivity type. In addition, an angle part means a part where straight lines or curved lines cross each other so as to have an edge part, and a corner part means a part where a straight line or a curved line changes its direction in spite of having an edge part or not. "A corner part has a curved line without having an angle of 90 degrees or less" means that a part of a cross point is made in a curved line by eliminating an angle part in case that an inner angle of the cross point of two lines is 90 degrees or less, and a corner part is not necessary to be made in a curved line in case that an inner angle of a cross point of two lines is 90 degrees or more as shown by α in Fig. 2(c).

It is preferable that the light transmitting conductive layer is formed such that each of corner parts has a curved line, with not having an angle part in outer periphery part, thereby damage to semiconductor layers can be inhibited since electric field does not concentrate at corner parts of the light transmitting conductive layer. And it is preferable that an outer shape of the light transmitting conductive layer is formed smaller than that of the mesa-like semiconductor lamination portion and has an approximately similar shape to that of the mesa-like semiconductor lamination portion.

Moreover, when the substrate is formed with an insulating substrate and the second electrode is provided on a surface of the second conductivity type layer exposed by etching a part of the semiconductor lamination portion, it is preferable that even when any one of corner parts of the semiconductor lamination portion opposing to the second electrode has an angle larger than 90 degrees, the corners are formed such that each of the corner parts has a curved line with not having an angle part, and the mesa-like semiconductor lamination portion is formed such that all of the corner parts have a curved line respectively, in a whole periphery in a plan shape.

In addition, when the substrate is formed with a semiconductor substrate, and the second electrode is formed on a back surface of the substrate, it is preferable that each of angle parts of a quadrilateral shape in a plan shape of the semiconductor lamination portion is formed in an arcuate shape.

### EFFECT OF THE INVENTION

Since there is no angle part having an angle of 90 degrees or less in an outer shape of semiconductor layers by using a structure of the present invention, it is avoided that only an angle part is suffered from damage of approximately two times by receiving damage of the energy of the plasma, from adjacent two lines at a corner part, even when the mesa-like semiconductor lamination portion is exposed to plasma while dry etching at the time of forming the mesa-like semiconductor lamination portion for exposing a conductivity layer of a lower layer by etching a part of the semiconductor lamination portion, and thereby the semiconductor layers are prevented from being applied with a locally big damage. As a result, damage is prevented from concentrating at the corner parts of semiconductor layers, especially of an active layer, and the semiconductor layers are not partially deteriorated. Therefore, a nitride semiconductor light emitting device excellent in reliability can be obtained which can inhibit spreading of deterioration within a whole semiconductor layers from a weak part because parts partially weak are eliminated, maintain light emitting characteristics highly because of inhibiting of deterioration even in long time operation, and endure sufficiently to entering of static electricity or the like.

### BRIEF DESCRIPTION OF THE DRAWINGS

Fig. 1 is a plan view and a cross-sectional view explaining an embodiment of the semiconductor light emitting device according to the present invention.
Fig. 2 is a figure explaining that the semiconductor light emitting device according to the present invention is hardly suffered from damage.
Fig. 3 is a plan view and a cross-sectional view explaining another embodiment of the semiconductor light emitting device according to the present invention.
Fig. 4 is a cross-sectional view and a plan view explaining an example of a nitride semiconductor light emitting device by the prior art.

### EXPLANATION OF LTTERS AND NUMERALS

1: substrate
2: low temperature buffer layer
3: n-type layer
4: active layer
5: p-type layer
6 : semiconductor lamination portion
6a: mesa-like semiconductor lamination portion
7: light transmitting conductive layer
8: p-side electrode
9: n-side electrode

### THE BEST EMBODIMENT OF THE PRESENT INVENTION

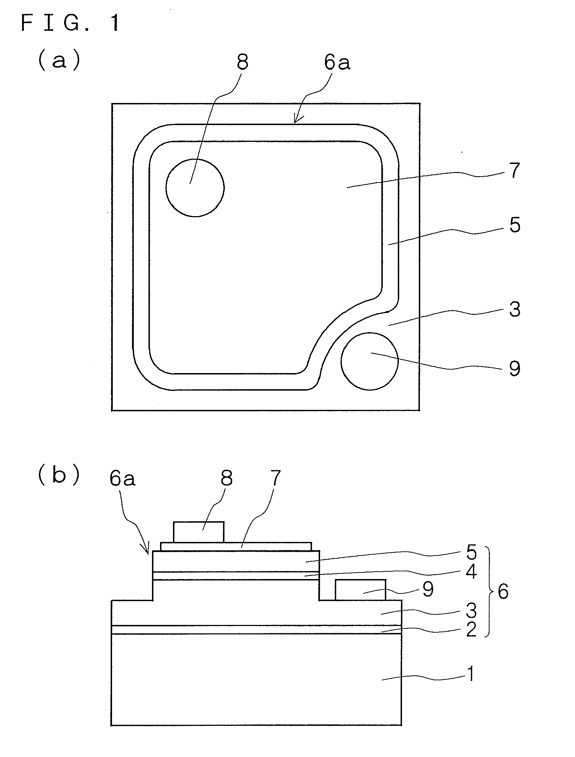

An explanation will be given below of a semiconductor light emitting device according to the present invention in reference to the drawings. There are shown in Fig. 1 a plan view and a cross-sectional view explaining a chip of the semiconductor light emitting device according to the present invention in which, for example, nitride semiconductor layers suitable for emitting blue light are laminated.

As shown, for example, in Fig. 1, the semiconductor light emitting device according to the present invention is formed as follows. A semiconductor lamination portion 6 is formed on a surface of a substrate 1 made of sapphire (single crystal of Al₂O₃) or the like, by laminating semiconductor layers made of nitride semiconductor including a first conductivity type layer and a second conductivity type layer. Then, a light transmitting conductive layer 7 is formed on the semiconductor lamination portion 6 and a first electrode (for example, a p-side electrode 8) electrically connected to the first conductivity type layer (for example, a p-type layer 5), which is formed on a surface side of the semiconductor lamination portion 6, through the light transmitting conductive layer 7, and a second electrode (for example, an n-side electrode 9 electrically connected to the second conductivity type layer (for example, a n-type layer 3) of the lower layer side of the semiconductor lamination portion 6. In the example shown in Fig. 1, an insulating substrate such as a sapphire substrate is used for the substrate 1 and the n-side electrode 9 is formed on an exposed surface of the n-type layer 3 exposed by etching a part of the semiconductor lamination portion 6. In the present invention, as an explanatory plan view is shown in Fig. 1, a mesa-like semiconductor lamination portion 6a is formed by removing a part of the semiconductor lamination portion 6 around a chip by etching, and the mesa-like semiconductor lamination portion 6a is formed such that a corner part having an angle of 90 degrees or less is rounded and has a curved line in a plan shape, thereby not to have an angle of 90 degrees or less on corner parts.

Namely, since nitride semiconductor is very hard, cracks easily occur not only in a part for dividing but also in inside parts at the time of dividing a wafer into chips by dicing or scribing, and also easily lead to decrease of internal quantum efficiency. Therefore, when the n-type layer is exposed in order to form the n-side electrode 9, a groove part is formed at the same time by dry etching of a part for dividing into chips, namely the semiconductor lamination portion 6 around the chip. Since the dry etching is carried out over an active layer 4, the n-type layer 3 is exposed and a mesa-like semiconductor lamination portion 6a is formed. In the dry etching, since the chip is approximately square, the groove for dividing (dividing groove) is formed in an approximately rectangular shape around the chip as shown in Fig. 2(a), and the n-type layer 3 is exposed connected to the dividing groove only at a part for forming the n-side electrode. The part etched is shown by oblique lines in Fig. 2(a).

As described above, the present inventors examined and studied earnestly a cause of breaking down which easily occurs in nitride semiconductor by being applied with a surge or reverse voltage, or long time operation. And as a result, it was found that if an angle part exists where adjacent lines cross each other in an angle of 90 degrees or less in a plan shape, such as an angle in a quadrilateral shape, semiconductor layers at the angle part are suffered from damage by receiving plasma energy P from the adjacent two side walls as shown in Fig. 2(a), and the damage spreads inside of the semiconductor layers, thereby, a whole semiconductor layer becomes a condition suffered from the damage, as a result, break down or remarkable deterioration of light emitting characteristics arises by the damage in the active layer having an especially high resistance, by being caused by small reverse voltage and severe operation such as long time operation.

Further, it was found that a problem can be solved such that a light emitting device breaks down easily or light emitting characteristics deteriorates easily, by spreading of the damage to a whole semiconductor layer, since such local damage does not arise because plasma p is prevented from irradiating twice and locally and the plasma p is irradiated evenly from whole surrounding, by rounding an angle part having an angle of 90 degrees or less in a curved line shape such as an arc as shown in Fig. 2(b). Namely, although the damaged part gives bad influence to characteristics or the like by spreading of the damage within a whole semiconductor layer when there is a damaged part in a part of semiconductor layers, since there is no damaged part by removing beforehand such part being possibly damaged, electric characteristics of the semiconductor layers can be prevented from deteriorating because the damage does not spread within a whole semiconductor layer.

Although the deterioration caused by double irradiation at an angle part is apt to occur, since double irradiation from the two sides occurs necessarily when the angle part of a corner part where two sides cross each other has an angle of 90 degrees or less, the deterioration is suppressed comparatively since the double irradiation from the two sides hardly occur when an angle α is larger than 90 degrees as shown in Fig. 2(c). Then, it is not always necessary to form the angle part in a curved line shape in an angle part having an angle larger than 90 degrees, however it is preferable that a plan shape of a mesa-like semiconductor lamination portion 6 is formed by a curved line having no angle part, by eliminating all angle parts including even such angle part, because the corner part can be formed so as not to be suffered from damage. Especially, as shown in Fig. 2(c), it is preferable to form a corner part by a curved line by eliminating an angle part at a part of the mesa-like semiconductor lamination portion 6a opposing to the n-side electrode not shown in the figure, because electric field is apt to concentrate.

In an example shown in Fig. 1(a), a plan shape of the light transmitting conductive layer 7 is formed by a curved line at its corner parts, same as at those of the semiconductor lamination portion 6a. Although the reason why each of the corner parts of the light transmitting conductive layer 7 is formed in a round shape has no direct relationship with a means against the above described double irradiation of plasma, break down or deterioration of characteristics caused by a surge or long time operation is prevented furthermore, by preventing concentration of an electric field at the corner parts of the mesa-like semiconductor lamination portion 6a which is apt to be suffered from damage because electric current easily flows in the light transmitting conductive layer 7 and the electric field is apt to concentrate especially at the corner parts. In addition, the light transmitting conductor layer 7 may be formed on a whole surface of the mesa-like semiconductor lamination portion 6a and in a perfectly same plan shape as that of the mesa-like semiconductor lamination portion 6a, or may be formed so that the light transmitting conductor layer 7 is arranged to be located inside the mesa-like semiconductor lamination portion 6a as shown in Fig. 1(a). In this case, a plan shape of the light transmitting conductive layer 7 is preferably formed parallel (similar shape) to that of the mesa-like semiconductor lamination portion 6a. It is because electric current to semiconductor layers can be uniformed easily.

The semiconductor lamination portion 6 is formed, for example, in a structure described below. There are laminated following layers in order respectively: a low temperature buffer layer 2 made of, for example, GaN and having a thickness of approximately 0.005 to 0.1 *µ*m; the n-type layer 3 made of GaN doped with Si or AlGaN based compound and having a thickness of approximately 1 to 10 *µ*m, an active layer 4, having a structure of a multiple quantum well (MQW), formed in a thickness of approximately 0.05 to 0.3 µm, by laminating 3 to 8 pairs of well layers made of In_{0.13}Ga_{0.87}N and having a thickness of 1 to 3 nm, and barrier layers made of GaN and having a thickness of 10 to 20 nm; and the p-type layer 5 made of p-type GaN or AlGaN based compound semiconductor and having a thickness of approximately 0.2 to 1 µm. Although both of the n-type layer 3 and p-type layer 5 are composed of single layer in the example shown in Fig. 1, double layers may be formed of, for example, a barrier layer (a layer with a large band gap energy), which confines carrier easily, made of AlGaN based compound and formed at the active layer side, and a contact layer, which raises carrier density easily, made of GaN and formed at an opposite side of the active layer 4, furthermore, other layers such as a high temperature buffer layer of undope, n-type or the like on the low temperature buffer layer, a super lattice layer releasing strains between each layer, or the like, may be interposed. And these layers may be formed by other nitride semiconductor layer.

Although in this example, a double hetero structure is shown in which the active layer 4 is sandwiched by the n-type layer 3 and the p-type layer 5, a structure of a p-n junction can be used in which the n-type layer and the p-type layer are directly joined. The active layer 4 is not limited to the MQW structure described above, a single quantum well structure (SQW) or a bulk structure can be employed.

The n-type layer is exposed by etching a surrounding region of a chip of the semiconductor lamination portion 6 and a part for forming an n-side electrode. At this time, etching is carried out so that a plan shape of the mesa-like semiconductor lamination portion 6a, which is left without being etched, has no angle of 90 degrees or less, a corner part being in a curved line shape as described above. Concretely, the mesa-like semiconductor lamination portion 6a is formed which has a corner part with not having an angle part but a curved line shape only by carrying out the same dry etching process as conventional by forming a mask so as to round such corner part at the time of forming the mask for etching. The dry etching can be carried out by plasma etching using gasses of chlorine and silicon tetrachloride for etchant.

On the semiconductor lamination portion 6, the light transmitting conductive layer 7 made of ZnO, a specific resistivity of which is set to approximately 5×10⁻⁴ Ω·cm by doping, for example, Ga, is formed in a thickness of approximately 0.1 to 10 µm, for example 0.5 µm. Then, the n-side electrode 9 for ohmic contact is formed on the n-type layer 3 exposed by etching and removing a part of the semiconductor lamination portion 6, with an alloy layer formed by sintering laminated layers of a Ti film of a thickness of approximately 0.01 1 µm and an Al film of a thickness of approximately 0.25 /µm, at a temperature of approximately 600°C, and the p-side electrode 8 is formed on a part of the light transmitting conductive layer 7, by a laminating structure of a Ti film of a thickness of approximately 0.1 µm and an Au film of a thickness of approximately 0.3 µm. A passivation film (not shown in figures) made of SiO₂ or the like is formed on the whole surface except those of the p-side electrode 8 and the n-side electrode 9. As the light transmitting conductive layer 7 is not limited to ZnO, but ITO or a thin alloy layer of Ni and Au having a thickness of approximately 2 to 100 nm can be used and diffuse electric current to whole part of a chip while transmitting light.

According to the present invention, there hardly exists a part excessively exposed to plasma of dry etching, and a part locally suffered from damage is not formed in semiconductor layers, since the mask is patterned so as not form an angle part having an angle of 90 degrees or less.

And next, an explanation on a method for manufacturing the semiconductor light emitting device shown in Fig. 1 will be given below. The semiconductor lamination portion is formed by a method of metal organic compound vapor deposition (MOCVD), supplying necessary reaction gasses such as a reactant gas like trimethyl gallium (TMG), ammonia (NH₃), trimethyl aluminium (TMA), trimethyl indium (TMI) or the like, and a dopant gas like SiH₄ for making an n-type, or a dopant gas like biscyclopentadienyl magnesium (Cp₂Mg).

At first, the low temperature buffer layer 2 made of a GaN layer is formed on an insulating substrate 1 made of, for example sapphire, in a thickness of approximately 0.005 to 0.1 µm, at a low temperature of, for example approximately 400 to 600 °C, thereafter, the n-type layer (barrier layer) 3 made of n-type GaN is formed in a thickness of approximately 1 to 10 µm by raising a temperature to a high temperature of approximately 600 to 1200 °C. And at a lowered temperature of 400 to 600 °C, the active layer 4 is formed which has a structure of a multiple quantum well (MQW) formed in a thickness of approximately 0.05 to 0.3 µm by laminating 3 to 8 pairs of well layers made of, for example, In_{0.13}Ga_{0.87}N and having a thickness of 1 to 3 nm, and barrier layers made of GaN and having a thickness of 10 to 20 nm. And, the p-type layer 5 made of GaN is laminated 0.2 to 1 *µ*m thick in total by raising a temperature in a growth furnace to approximately 600 to 1200 °C.

Thereafter, a part (region surrounding a chip and region for forming the n-side electrode) of the semiconductor lamination portion 6, which is etched, is exposed by the steps of: forming a protective film made of SiN or the like is deposited on a surface thereof and annealing is carried out at a temperature of approximately 400 to 800 °C for approximately 10 to 60 minutes to activate a p-type dopant. Thereafter, a photo resist film is formed on the whole surface, and patterned by a photolithography process. At this time, the mask is formed by patterning the photo resist film by forming a part, which has possibility of an angle of 90 degrees or less, in a curved line shape in order not to form an angle of 90 degrees or less. A desired region, such as a surrounding region of a chip or the like, can be etched in a desired shape, by setting a wafer in an inductively coupled plasma etching apparatus, flowing, for example, chlorine gas and silicon tetrachloride gas, and introducing RF power.

Subsequently, the light transmitting conductive layer 7 is formed by forming a ZnO layer doped with, for example, Ga in a thickness of approximately 0.5 *µ*m by a method of such as MBE, sputtering, vacuum vapor deposition, PLD, ion plating or the like. Then, the n-side electrode 9 is formed on the exposed surface of the n-type layer 3 by forming a Ti film having a thickness of 0.1 *µ*m and an Al film having a thickness of 0.25 *µ*m and by sintering to make an alloy by applying a heat treatment of approximately 600 °C. And the p-side electrode 8 is formed similarly on a part of the light transmitting conductive layer 7 by forming a Ti film having a thickness of 0.1 µm and an Au film having a thickness of 0.3 µm by using a lift-off method. As a result, an LED chip having a structure shown in Fig. 1 is formed.

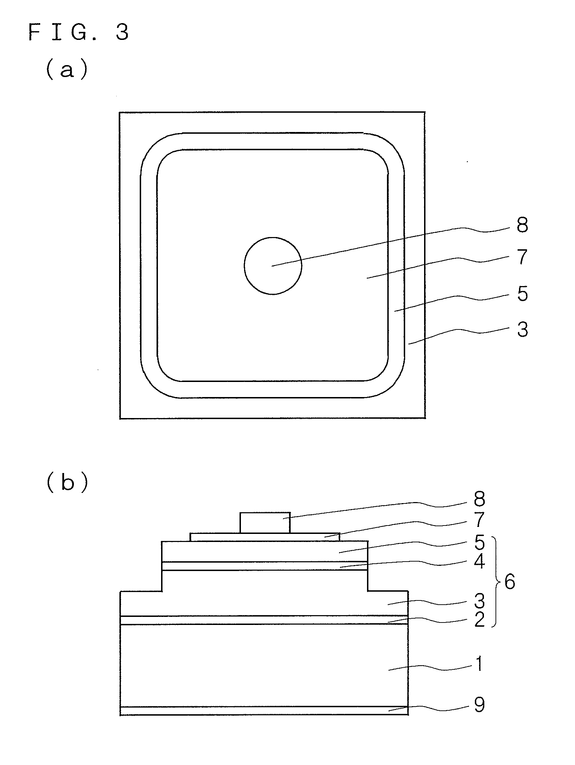

In the above-described example, the n-side electrode 9 is formed by exposing the n-type layer 3 by etching a part of the semiconductor lamination portion 6, because the substrate is the sapphire substrate of an insulating substrate, and at the same time a surrounding region of the chip is etched. However, even in the case that the substrate is a semiconductor substrate such as SiC, it is preferable that a portion for dividing is etched beforehand by dry etching because the nitride semiconductor is apt to crack at the time of dividing into chips as described above. In this case, the dry etching is necessary to be carried out so as not to form angle parts in a plan shape of the mesa-like semiconductor lamination portion 6a left by the etching. The example is shown in Fig. 3. In this example, since the substrate is not an insulating substrate but a semiconductor substrate, the electrode 9 is not formed on the n-type layer 3 exposed by removing a part of the semiconductor lamination portion 6 by etching, but formed on a back surface of the semiconductor substrate 1, and a process is similar to those of the above-described example, except only forming a plan shape of the mesa-like semiconductor lamination portion 6a, which is formed in a shape of a quadrilateral shape, the corner parts are formed in a curved line such as an arc.

Namely, a semiconductor lamination portion 6 composed of a low temperature buffer layer 2, an n-type layer 3, an active layer 4 and a p-type layer 5, is formed on the SiC substrate 1, and a surrounding region of a chip is etched. In this case, a p-side electrode 8 is formed on a surface of a light transmitting conductive layer 7 approximately at a center of the chip by using same material as described above, and an n-side electrode 9 is formed on the whole back surface of the SiC substrate 1 by forming, for example, a Ni film.

### INDUSTRIAL APPLICABILITY

According to the present invention, a light emitting device emitting blue light, ultraviolet light, or the like, having a structure, in which break down caused by static electricity or long time operation hardly arises, can be obtained, and can be used for white light sources, light sources or pilot lamps for electrical appliances of wide range such as for lighting or the like, lighting apparatus, disinfection apparatus, or the like.

## Claims

1. A semiconductor light emitting device comprising:
a substrate;
a semiconductor lamination portion made of nitride semiconductor provided on the substrate, the semiconductor lamination portion including a first conductivity type layer and a second conductivity type layer;
a light transmitting conductive layer provided on the semiconductor lamination portion;
a first electrode provided on the light transmitting conductive layer and electrically connected to the first conductivity type layer which is provided on a surface side of the semiconductor lamination portion; and
a second electrode provided electrically connected to the second conductivity type layer of a lower side of the semiconductor lamination portion,
wherein a mesa-like semiconductor lamination portion is formed by etching the semiconductor lamination portion of at least a surrounding region of a chip such that a corner part having an angle of 90 degrees or less is rounded and has a curved line in a plan shape, thereby not to have an angle of 90 degrees or less on corner parts.

2. The semiconductor light emitting device according to claim 1, wherein the light transmitting conductive layer is formed such that each of corner parts has a curved line, with not having an angle part in outer periphery part.

3. The semiconductor light emitting device according to claim 2, wherein an outer shape of the light transmitting conductive layer is formed smaller than that of the mesa-like semiconductor lamination portion and has an approximately similar shape to that of the mesa-like semiconductor lamination portion.

4. The semiconductor light emitting device according to claim 1, 2 or 3, in which the substrate is formed with an insulating substrate and the second electrode is provided on a surface of the second conductivity type layer exposed by etching a part of the semiconductor lamination portion,
wherein even when any one of corner parts of the semiconductor lamination portion opposing to the second electrode has an angle larger than 90 degrees, the corners are formed such that each of the corner parts has a curved line with not having an angle part, and the mesa-like semiconductor lamination portion is formed such that all of the corner parts have a curved line respectively, in a whole periphery in a plan shape.

5. The semiconductor light emitting device according to claim 1, 2 or 3, in which the substrate is formed with a semiconductor substrate, and the second electrode is formed on a back surface of the substrate,
wherein each of angle parts of a quadrilateral shape in a plan shape of the semiconductor lamination portion is formed in an arcuate shape.
